# EUROPEAN PATENT SPECIFICATION

(11) **EP 1 183 905 B1**
(45) Date of publication and mention of the grant of the patent: **24.09.2003**
(21) Application number: 00939183.0
(22) Date of filing: 31.05.2000
(51) Int. Cl.: H04R 9/00

(54) **MOUNTING OF THE COIL IN AN ELECTROACOUSTIC TRANSDUCER**
SPULENBEFESTIGUNG IN EINEM ELEKTROAKUSTISCHEN WANDLER
CONSTRUCTION DE BOBINE POUR UN TRANSDUCTEUR ELECTRO-ACOUSTIQUE

(30) Priority: 01.06.1999 NL 1012208
(43) Date of publication of application: 06.03.2002
(73) Proprietor: SonionMicrotronic Nederland B.V., 1014 BM Amsterdam (NL)
(72) Inventor: VAN HALTEREN, Aart, Zeger, NL-1447 EG Hobrede (NL); WILMINK, Engbert, NL-2611 PT Delft (NL); DOLLEMAN, Hendrik, NL-1566 LD Assendelft (NL); VAN HAL, Paul, Christiaan, NL-1628 TJ Hoorn (NL)
(74) Representative: Prins, Adrianus Willem
(86) International application number: NL0000374
(87) International publication number: WO00074436

(56) References cited:
- EP-A- 0 851 710
- WO-A-91/10243
- US-A- 5 193 116

## Description

This invention relates to an electroacoustic transducer comprising a case accommodating an armature with at least two armature legs; a coil with an air gap, which coil is fitted with the air gap around an armature leg; a magnetic element with an air gap, which magnetic element is likewise fitted with the air gap around the one armature leg, the air gap of the coil and that of the magnetic element being located substantially in line with each other; a diaphragm; a connecting element which couples a free end of the one armature leg to the diaphragm; and a printed circuit board with terminals for the wires of the coil and for external connections, the coil being attached to the printed circuit board.

Such transducers find application especially, but not exclusively, in hearing aids.

Such a transducer is known, for instance, from WO 91/10243. This publication recognizes the problems in manipulating the lead wires of the coil. These wires are often microscopically thin and must be connected to more robust connecting wires connecting the coil to the further circuits in the hearing aid.

In this prior art reference, it is proposed as a solution to attach the coil, preferably automatically, directly upon winding, to terminal areas of a flexible printed circuit board, whereby first the lead wires of the coil are attached, for instance by welding or soldering, to the terminal areas of the printed circuit board and subsequently a side face of the coil is attached, for instance by adhesion, to the printed circuit board. The printed circuit board further has additional terminal areas to which the external connecting wires can be attached, for instance by soldering.

A flexible printed circuit board has the advantage that it can be laid in the case in any desired manner. It is often also possible, however, to use a printed circuit board from rigid material.

A problem in existing coil constructions which are not already mounted on a printed circuit board, and in coil constructions which, as in the technique according to WO 91/10243, have already been pre-mounted on a, possibly flexible, printed circuit board, is that positioning the coil with respect to the other parts of the transducer, in particular with respect to the arm of the armature and with respect to the air gap of the magnetic element, is a painstaking, labor-intensive and time-consuming and hence costly activity.

The invention contemplates presenting a solution to this problem and to that end provides a transducer of the above-mentioned type, characterized in that the coil is attached to the printed circuit board by an end face thereof, which is located essentially perpendicularly to the longitudinal axis of the air gap, and that the printed circuit board is provided with an opening which corresponds with the air gap of the coil. Preferably, the printed circuit board is provided with at least one recess adapted to cooperate with at least one other leg of the armature.

The invention further provides a coil construction for an electroacoustic transducer, comprising a coil with an air gap and a printed circuit board with terminals for wires of the coil and external connections, characterized in that the coil is attached to the printed circuit board by an end face thereof, which is located essentially perpendicularly to the longitudinal axis of the air gap, and that the printed circuit board is provided with an opening which corresponds with the air gap of the coil.

The invention is based on the insight that the printed circuit board can be fixedly connected to the armature and that, as a result, a coil fixedly connected to the printed circuit board can be accurately positioned with respect to the armature. By means of an automatic manufacturing process, for instance as elucidated in WO 91/10243, it is possible to position the coil very accurately with respect to the printed circuit board and to attach it thereto, for instance by means of adhesive. When thereupon the printed circuit board can be positioned with respect to the armature very accurately, the position of the coil with respect to the armature is thereby determined very accurately as well. The operation required for this purpose consists in sliding the printed circuit board over the armature, which is an operation which can be performed simply and fast. The invention thus provides an excellent solution to the above-outlined problem.

Hereinbelow, the invention will be further explained on the basis of an exemplary embodiment, with reference to the drawings. In the drawings:
Fig. 1 is a cross section of an electromagnetic transducer known per se;
Fig. 2a is a perspective view of a coil mounted on a printed circuit board, for an electromagnetic transducer according to the invention;
Fig. 3a is an exploded view of a magnetic body, a coil construction according to the invention, and an armature; and
Fig. 3b shows the parts shown in Fig. 3a in assembled condition.

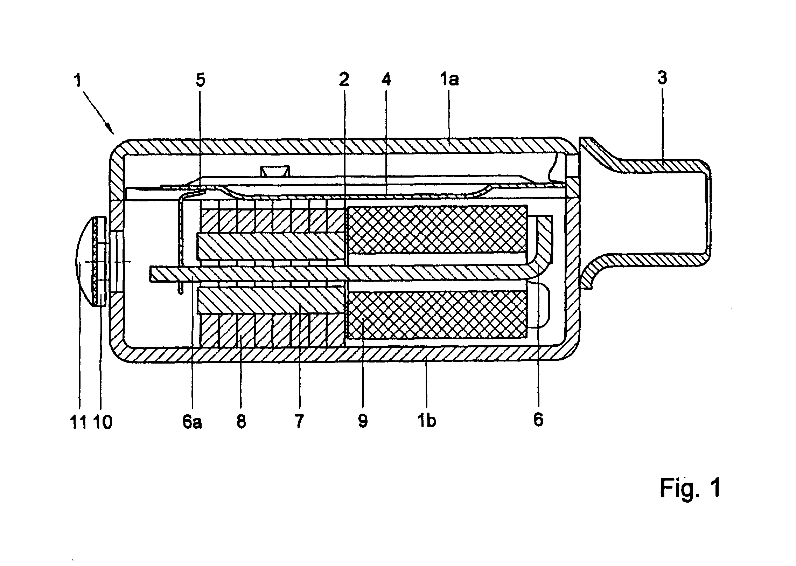

In elucidation of the use of the coil construction according to the invention in an electroacoustic transducer, Fig. 1 schematically shows a transducer known per se for use in a hearing aid.

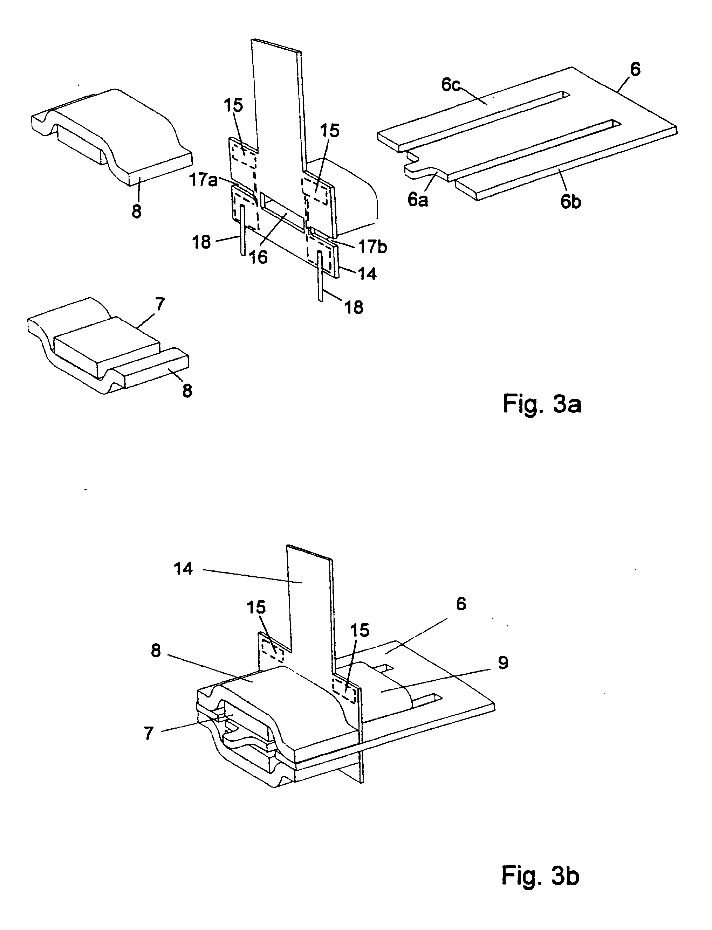

The transducer comprises a case 1 with an upper case portion 1a and a lower case portion 1b. The interior of the case communicates with the surroundings via a snout 3. In the case, a diaphragm 4 is fitted in such a manner that it can move freely relative to the case, for instance in the manner described in Dutch patent application 1004877 = EP-A-0 851 710. The diaphragm communicates via a so-called reed 5 with the end of a central armature leg 6a of an armature 6. In this case, the armature is E-shaped, as appears more clearly from Fig. 3, but may also be U-shaped.

Provided around the armature leg are a magnet 7, which is accommodated in a pole piece 8, and a coil 9. Both the magnet and the coil have a central opening disposed around the armature leg 6a, such that the armature leg can move freely in these openings. Between the coil and the magnet/pole piece combination, an adhesive film 2 is provided to fix these parts with respect to each other. The coil lead wires, not shown, are passed through the case to a printed circuit board 10 with terminals 11 to which the coil lead wires and the external connecting wires can be attached, for instance by soldering.

Electrical signals fed via the lead wires of the coil provide for a movement of the armature leg 6a, which movement is transmitted via the reed to the diaphragm 4, which converts the movement into the sound signals to be perceived via the snout 3.

It will be clear that it is a painstaking and labor-intensive activity to position the coil in the transducer shown in Fig. 1 and to connect the coil wires to the print 10.

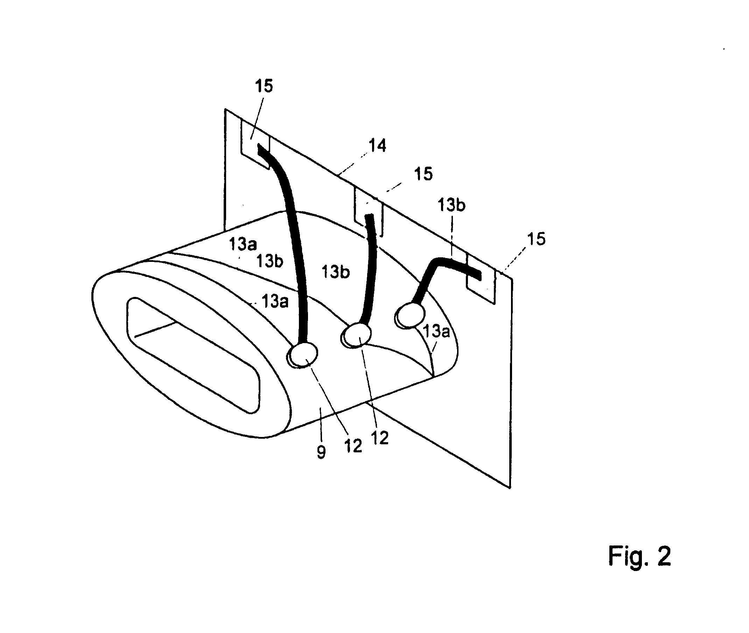

Fig. 2 schematically shows a view of the coil construction according to the invention. The core-free coil 9 may be provided, on the circumference thereof, with terminals 12 for the coil lead wires 13a, from which terminals 12 further wires 13b lead to the printed circuit board 14. It is equally possible, however, to connect the coil lead wires 13a directly to the terminal areas 15 on the printed circuit board 14, which may be flexible or rigid, as desired. The coil body 9 is attached, for instance by adhesion, to the printed circuit board through a coil end face, which is located essentially perpendicularly to the longitudinal axis of the central opening in the coil. This can be done with great accuracy in an automatic manner.

The printed circuit board further comprises terminal areas, not shown, for attaching connections to the exterior of the transducer. These further terminal areas are connected through print tracks to the terminal areas 15, or are part thereof.

An elegant solution for providing a connection between the printed circuit board 14 and the exterior of the transducer is to provide pins which at one end are connected, for instance by soldering, to the terminal areas on the printed circuit board 14 and which project outside through openings in the case wall to be connected to a printed circuit board present there, having further electronics for signal processing. Such pins can be rigid or slightly flexible and are to be passed, insulated, through the openings provided in the case wall for that purpose. In Fig. 3a two of such pins 18 are schematically shown.

As clearly shown in Figs. 3a and b, the printed circuit board 14 is provided with an opening 16 and recesses 17a, b, while the opening 16 corresponds with the air gap of the coil and can be slid over the armature leg 6a. The opening 16 is so dimensioned that the free movement of the armature leg is not hampered. The recesses 17a and b are slid over the two other legs 6b and 6c of the E-shaped armature 6. Naturally, the recesses 17a, b, instead of being slotted, can also be closed all round or have any other shape that is suitable to be slid over the armature legs 6b, c.

The recesses 17a and b fit accurately over the armature legs 6b and 6c, so that the position of the printed circuit board 14 with respect to the armature is very accurate. Because positioning the coil 9 with respect to the printed circuit board can also be done very accurately, the problem of positioning the coil body with respect to the central armature leg has been resolved in a simple manner.

It will be clear that the principle according to the invention is also applicable in U-shaped armatures, that is, an armature where either of the legs 6b or 6c is absent.

It will also be clear that there are other possibilities of accurately positioning the printed circuit board with respect to the armature than by way of recesses 17a and b.

## Claims

1. An electroacoustic transducer comprising a case accommodating an armature (6) with at least two armature legs (6a,6b,6c); a coil (9) with an air gap, which coil is fitted with the air gap around one armature leg (6a); a magnetic element (7) with an air gap, which magnetic element (7) is likewise fitted with the air gap around the one armature leg (6a), the air gap of the coil and that of the magnetic element being located in line with each other; a diaphragm; a connecting element which couples a free end of the one armature leg to the diaphragm; and a printed circuit board (14) with terminals (15) for the wires of the coil and for external connections, the coil being attached to the printed circuit board (14), **characterized in that** the coil (9) is attached to the printed circuit board (14) by an end face thereof, which is located essentially perpendicularly to the longitudinal axis of the air gap, and that the printed circuit board (14) is provided with an opening (16) which corresponds with the air gap of the coil.

2. An electroacoustic transducer according to claim 1, **characterized in that** the printed circuit board is further provided with at least one recess adapted to cooperate with at least one other leg of the armature.

3. An electroacoustic transducer according to claim 2, **characterized in that** the armature is E-shaped, and that the printed circuit board is provided with two recesses, respectively cooperating with an outer leg of the armature.

4. An electroacoustic transducer according to any one of claims 1-3, **characterized in that** the coil is glued to the printed circuit board.

5. An electroacoustic transducer according to any one of claims 1-4, **characterized in that** for the purpose of external connections, pins are connected to the terminal areas on the printed circuit board, which pins project through the wall of the case.

6. A coil construction for an electroacoustic transducer according to any one of claims 1-5, comprising a coil with an air gap and a printed circuit board with terminals for wires of the coil and external connections, **characterized in that** the coil is attached to the printed circuit board by an end face thereof which is located essentially perpendicularly to the longitudinal axis of the air gap and that the printed circuit board is provided with an opening which corresponds with the air gap.

7. A coil construction according to claim 6, **characterized in that** the printed circuit board is provided with at least one recess along the circumferential edge thereof.

## Patentansprüche

1. Elektroakustischer Wandler mit einem Gehäuse, in dem ein Anker (6) mit mindestens zwei Ankerschenkeln (6a, 6b, 6c) untergebracht ist; einer Spule (9) mit einem Luftspalt, die mit dem Luftspalt um einen Ankerschenkel (6a) montiert ist; einem magnetischen Element (7) mit einem Luftspalt, das ebenfalls mit dem Luftspalt um den einen Ankerschenkel (6a) montiert ist, wobei der Luftspalt der Spule und der Luftspalt des magnetischen Elements miteinander fluchtend angeordnet sind; einer Membran; einem Verbindungselement, das ein freies Ende des einen Ankerschenkels mit der Membran verbindet; und einer gedruckten Leiterplatte (14) mit Anschlussklemmen (15) für die Drähte der Spule und für Außenanschlüsse, wobei die Spule an der gedruckten Leiterplatte (14) angebracht ist, **dadurch gekennzeichnet, dass** die Spule (9) an der gedruckten Leiterplatte (14) mittels einer ihrer Stirnseiten angebracht ist, die weitgehend senkrecht zur Längsachse des Luftspalts angeordnet ist, und dass die gedruckte Leiterplatte (14) mit einer Öffnung (16) versehen ist, die dem Luftspalt der Spule entspricht.

2. Elektroakustischer Wandler nach Anspruch 1, **dadurch gekennzeichnet, dass** die gedruckte Leiterplatte außerdem mit mindestens einer Aussparung versehen ist, die geeignet ist, mit mindestens einem Schenkel des Ankers zusammenzuwirken.

3. Elektroakustischer Wandler nach Anspruch 2, **dadurch gekennzeichnet, dass** der Anker E-förmig ist und dass die gedruckte Leiterplatte mit zwei Aussparungen versehen ist, die jeweils mit einem Außenschenkel des Ankers zusammenwirken.

4. Elektroakustischer Wandler nach einem der Ansprüche 1 bis 3, **dadurch gekennzeichnet, dass** die Spule auf die gedruckte Leiterplatte geklebt ist.

5. Elektroakustischer Wandler nach einem der Ansprüche 1 bis 4, **dadurch gekennzeichnet, dass** für die Außenanschlüsse durch die Wand des Gehäuses ragende Anschlussstifte mit den Anschlussbereichen auf der gedruckten Leiterplatte verbunden sind.

6. Spulenaufbau für einen elektroakustischer Wandler nach einem der Ansprüche 1 bis 5 mit einer Spule mit einem Luftspalt und einer gedruckten Leiterplatte mit Anschlussklemmen für Drähte der Spule und Außenanschlüsse, dadurch g ekennzeichnet, dass die Spule an der gedruckten Leiterplatte mittels einer ihrer Stirnseiten angebracht ist, die weitgehend senkrecht zur Längsachse des Luftspalts angeordnet ist, und dass die gedruckte Leiterplatte mit einer Öffnung versehen ist, die dem Luftspalt entspricht.

7. Spulenaufbau nach Anspruch 6, **dadurch gekennzeichnet, dass** die gedruckte Leiterplatte mit mindestens einer Aussparung entlang ihrem Umfangsrand versehen ist.

## Revendications

1. Transducteur électroacoustique comprenant un boîtier recevant une armature (6) avec au moins deux jambes d'armature (6a, 6b, 6c) ; une bobine (9) avec un entrefer, laquelle bobine est ajustée avec l'entrefer autour d'une jambe d'armature (6a), un élément magnétique (7) avec un entrefer, lequel élément magnétique (7) est ajusté de manière identique avec l'entrefer autour d'une jambe d'armature (6a), l'entrefer de la bobine et l'entrefer de l'élément magnétique étant mutuellement placés en ligne ; un diaphragme ; un élément de connexion qui couple une extrémité libre d'une jambe d'armature au diaphragme ; et une carte de circuit imprimé (14) avec des bornes (15) pour les fils de la bobine et pour les connexions externes, la bobine étant fixée à la carte de circuit imprimé (14), **caractérisé en ce que** la bobine (9) est fixée à la carte de circuit imprimé (14) par sa face d'extrémité, qui est placée essentiellement perpendiculairement à l'axe longitudinal de l'entrefer, lorsque la carte de circuit imprimé (14) est pourvue d'une ouverture (16) qui correspond à l'entrefer de la bobine.

2. Transducteur électroacoustique selon la revendication 1, **caractérisé en ce que** la carte de circuit imprimé est, de plus, munie d'au moins un évidement conçu pour coopérer avec au moins une autre jambe de l'armature.

3. Transducteur électroacoustique selon la revendication 2, **caractérisé en ce que** l'armature est en forme de E et **en ce que** la carte de circuit imprimé est pourvue de deux évidements, coopérant respectivement avec une jambe externe de l'armature.

4. Transducteur électroacoustique selon l'une quelconque des revendications 1 à 3, **caractérisé en ce que** la bobine est collée sur la carte de circuit imprimé.

5. Transducteur électroacoustique selon l'une quelconque des revendications 1 à 4, **caractérisé en ce qu'**à des fins de connexions externes, des broches sont connectées aux zones des bornes sur la carte de circuit imprimé, lesquelles broches dépassent à travers la paroi du boîtier.

6. Construction de bobine pour un transducteur électroacoustique selon l'une quelconque des revendications 1 à 5, comprenant une bobine avec un entrefer et une carte de circuit imprimé avec des bornes pour les fils de la bobine et les connexions externes, **caractérisée en ce que** la bobine est fixée à la carte de circuit imprimé par sa face d'extrémité qui est placée essentiellement perpendiculairement à l'axe longitudinal de l'entrefer et **en ce que** la carte de circuit imprimé est pourvue d'une ouverture qui correspond à l'entrefer.

7. Construction de bobine selon la revendication 6, **caractérisée en ce que** la carte de circuit imprimé est pourvue d'au moins un évidement le long de son bord circonférentiel.
